# EUROPÄISCHE PATENTSCHRIFT

(11) **EP 0 565 946 B1**
(45) Veröffentlichungstag und Bekanntmachung des Hinweises auf die Patenterteilung: **02.12.1998**
(21) Anmeldenummer: 93105318.5
(22) Anmeldetag: 31.03.1993
(51) Int. Cl.: G01R 15/00

(54) **Direktabbildender Stromsensor**
Current sensor with direct measurement
Sonde de courant à action directe

(30) Priorität: 14.04.1992 DE 4212461
(43) Veröffentlichungstag der Anmeldung: 20.10.1993
(73) Patentinhaber: Vacuumschmelze GmbH, 63450 Hanau (DE)
(72) Erfinder: Lenhard, Friedrich, Dipl.-Ing., W-6450 Hanau 1 (DE); Nilius, Hans-Joachim, Dipl.-Ing., W-6453 Seligenstadt (DE); Hinz, Gerhard, Dipl.-Phys., W-8755 Alzenau (DE); Baum, Eckhard Dr., W-6455 Erlensee (DE)
(74) Vertreter: Epping, Wilhelm, Dr.-Ing.

(56) Entgegenhaltungen:
- EP-A- 0 320 341
- EP-A- 0 392 439
- DE-A- 3 303 945
- DE-B- 1 245 495

## Beschreibung

Die Erfindung betrifft einen direktabbildenden Stromsensor mit einem vom zu messenden Strom beeinflußten Magnetkern und einem den Fluß im Magnetkern erfassenden Magnetfeldsensor, dessen Ausgangssignal einer Auswerteschaltung zugeführt wird und als Meßgröße für den zu messenden Strom dient.

Im Unterschied zu Stromsensoren mit Kompensationswicklung, bei denen das durch den zu messenden Strom erzeugte Feld in einem Magnetkern durch einen Kompensationsstrom in einer Sekundärwicklung kompensiert wird und der Magnetfeldsensor in einem Luftspalt oder einem Teilluftspalt des Magnetkerns dazu dient, den Kompensationsstrom über eine Ansteuerschaltung so zu regeln, daß der Fluß im Magnetkern den Wert Null erreicht, verzichtet man bei direktabbildenden Stromsensoren auf die Kompensationswicklung, so daß das durch den Fluß bedingte Ausgangssignal des Magnetfeldsensors - zum Beispiel die Ausgangsspannung eines Hallgeneratos - als Maß für den zu messenden Strom herangezogen wird.

Direktabbildende Stromsensoren sind daher einfacher aufgebaut; allerdings müssen dafür einige Nachteile in Kauf genommen werden, wie z. B. die temperatur- und alterungsbedingte Änderung im Ausgangssignal des Magnetfeldsensors, eine prinzipbedingte geringere Abbildungsgenauigkeit, da bei endlichen Flüssen der Magnetkern nicht eine vollkommen lineare Kennlinie der Induktion Gegenüber der Feldstärke besitzt und vor allem eine schlechtere dynamische Impulswidergabe durch induktive Einkopplungen des Streuflusses des Magnetkerns in den Meßkreis, die vor allem bei sehr hohen Frequenzen wirksam werden.

Zur Vermeidung bzw. Verminderung dieser Nachteile ist es beispielsweise aus der DE-OS 33 03 945 bekannt, bei einem direktabbildenden Stromsensor mit einem Hallgenerator als Magnetfeldsensor in dem Luftspalt eines den Primärstrom führenden Leiter umgebenden Magnetkerns erstens die Zuleitungen zum Hallgenerator bifilar zu wickeln, so daß induzierte Spannungen in den Zuleitungen sich weitgehend aufheben, und zweitens einen temperaturabhängigen Transistor in der Auswerteschaltung vorzusehen, der die Temperaturabhängigkeit des Hallgenerators weitgehend kompensiert.

Dokument EP-A 0 320 341 beschreibt einen Stromsensor, bei dem der Strom durch eine Primärwicklung eines Transformators fließt, der Kern des Transformators einen Luftspalt enthält, in welchen ein Magnetfeldsensor eingesetzt ist, welcher ein Signal bildet, welches proportional zum Strom an der Primärwicklung des Transformators ist, und eine Sekundärwicklung, die mit einem Widerstand kurzgeschlossen ist, wobei eine zusätzliche Spannung an diesem Widerstand abgegriffen wird, die ebenfalls zur Bildung des Ausgangssignals verwendet wird. Die am Widerstand R abgegriffene Spannung ist proportional zur Stärke des zu messenden Stromes.

Für viele Anwendungen, beispielsweise für den Betrieb elektrisch angetriebener Fahrzeuge (Bahn, Elektro-Auto), sind einerseits sehr hohe Ströme zu erfassen und andererseits ist es wünschenswert, einen möglichst kostengünstigen Stromsensor mit noch ausreichender Meßgenauigkeit einzusetzen. Neben den höheren Kosten für den Einsatz eines stromkompensierten Stromsensors ist dieser besonders dann nachteilig, wenn sehr hohe Primärströme abzubilden sind, da dann die Kompensationswicklung ebenfalls eine nennenswerte Leistung erfordert.

Hier ist der Einsatz eines direktabbildenden Stromsensors vorteilhaft, zumal dessen Genauigkeit für die genannten und ähnliche Anwendungen in vielen Fällen ausreichend ist. Allerdings besitzt ein direktabbildender Stromsensor mit einem Magnetfeldsensor im Luftspalt eines Kerns bei sehr schnellen Stromänderungen, wie z. B. im Kurzschlußfalle, stoßartigen Belastungen sowie allgemein bei hohen Frequenzen den prinzipiellen Nachteil, daß sich induktive

Einkopplungen in den Zuleitungen zum Magnetfeldsensor den zu messenden Spannungen überlagern und so das Meßergebnis verfälschen. Gerade bei schnellen Stromänderungen ist es aber in vielen Fällen erforderlich, durch einen Regler einzugreifen oder Schutzmaßnahmen einzuleiten, so daß gerade hier eine ausreichend genaue Abbildung des Primärstromes wesentlich ist.

Die in den Zuleitungen und in dem Magnetfeldsensor selbst induzierten Spannungen sind von der Änderung des Primärstromes bzw. des Flusses im Magnetkern abhängig und steigen daher kontinuierlich mit zunehmender Frequenz, so daß trotz sorgfältiger Verlegung dieser Leitungen der Einsatzbereich derartiger direktabbildender Stromsensoren auf Werte unterhalb einer gewissen Grenzfrequenz beschränkt sind.

Aufgabe der vorliegenden Erfindung ist es nun, einen direktabbildenden Stromsensor vorzusehen, der bei sonst weitgehend gleichen Eigenschaften eine ausreichend genaue Abbildung des Primärstroms auch bei sehr hohen Frequenzen gewährleistet.

Diese Aufgabe wird erfindungsgemäß dadurch gelöst, daß zusätzlich zum Magnetfeldsensor eine ebenfalls vom Magnetfluß des zu messenden Stroms beeinflußte elektrische Spule vorgesehen ist, daß die in dieser Spule induzierte, der Stromänderung des zu messenden Stroms proportionale Spannung ebenfalls der Auswerteschaltung zugeführt wird und daß die Auswerteschaltung Verstärkerschaltungen enthält, deren frequenzabhängige Verstärkerkennlinien durch entsprechende Dimensionierung so gewählt sind, daß bei niedrigen Frequenzen vorwiegend das Ausgangssignal des Magnetfeldsensors und bei hohen Frequenzen vorwiegend die in der Spule induzierte Spannung zur Bildung des Gesamtausgangssignals des Stromsensors beiträgt.

Vorteilhafte Weiterbildungen des direktabbildenden Stromsensors nach der Erfindung sind in den Unteransprüchen beschrieben.

Im Gegensatz zu einem stromkompensierten Stromsensor wird also die zusätzliche elektrische Spule nicht dazu verwendet, den Magnetfluß in dem Magnetkern auf den Wert Null zu kompensieren, vielmehr wird diese Spule dazu verwendet, die bei direktabbildenden Stromsensoren und hohen Frequenzen unvermeidlichen induktiven Einkopplungen definiert zu erfassen und anstelle oder zusätzlich zum Ausgangssignal des Magnetfeldsensors bei hohen Frequenzen zur Abbildung des Stromes heranzuziehen.

Da somit für die zusätzliche elektrische Spule nur wenige Windungen erforderlich sind, um eine ausreichend hohe Spannung bei den höheren Frequenzen zu erzielen, kann man diese Wicklung im Prinzip aus einzelnen Bügeln zusammensetzen, die über eine gedruckte Schaltung miteinander zu einer Spule verbunden sind. Dies ist beispielsweise in der DE-PS 12 45 495 beschrieben. Diese Bügel können bei einem hochpermeablen Magnetkern voneinander relativ große Abstände haben, da der Streufluß des Magnetkerns relativ gering ist; sie können daher auch zur Befestigung des Magnetkerns auf einer Unterlage dienen.

Ausführungsbeispiele sind in den Figuren im einzelnen dargestellt. Es zeigen:
Fig. 1 eine Ansicht auf den Magnetkern und die zusätzliche elektrische Spule, deren Windungen hier den Magnetkern umschließen;
Fig. 2 eine ausführliche Schaltung für die Auswerteeinrichtung, anhand derer das Prinzip erklärt wird;
Fig. 3 eine vereinfachte Form der Auswerteschaltung, bei der die Ausgangssignale von Magnetfeldsensor und Spule einem gemeinsamen Verstärker zugeführt werden;
Fig. 4 eine Anordnung mit nur einer Spulenwindung im Luftspalt des Magnetkerns unter Verwendung eines Hallgenerators als Magnetfeldsensor;
Fig. 5 den Verlauf des Verstärkungsgrades der Verstärker V2 und V3 nach Fig. 2 in dB, abhängig von der Frequenz im Verhältnis zu einer Grenzfrequenz, bei der die Verstärkungsfaktoren der beiden Verstärker gleich groß sind;
Fig. 6 die Ausgangsspannung eines direktabbildenden Stromsensors bei schneller Änderung des zu messenden Stromes;
Fig. 7 den Verlauf der Ausgangsspannung bei ebenfalls schneller Änderung des Stromes in vergrößertem Maßstab unter Verwendung der erfindungsgemäßen Anordnung mit zusätzlicher elektrischer Spule;
Fig. 8 ein Blockschaltbild einer Motorsteuerung mit Kurzschlußüberwachung.

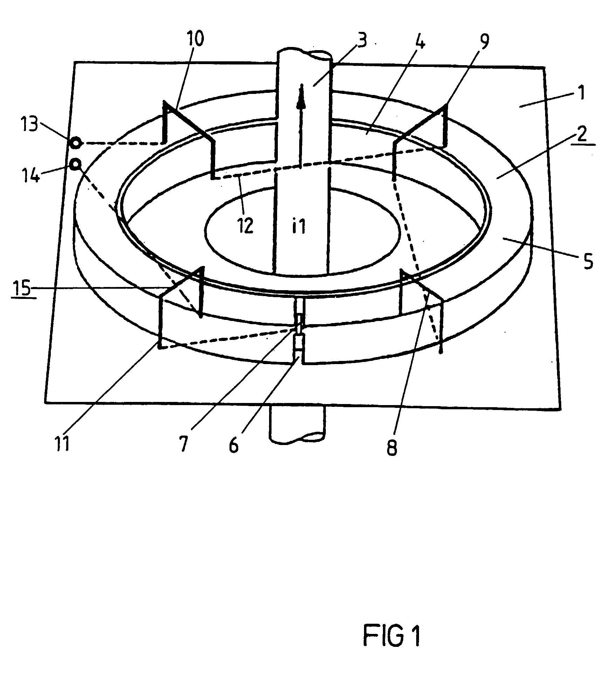

Fig. 1 zeigt auf einer Platte 1 einen ringförmigen Magnetkern 2, der einen Stromleiter 3 umgibt. In dem Stromleiter fließt der Strom i1, der durch den erfindungsgemäßen Stromsensor gemessen werden soll. Der Magnetkern 2 besteht aus einem nicht magnetischen Haltering 4 und einem Ringkern 5, in dem sich ein Luftspalt 6 befindet. Innerhalb des Luftspaltes 6 ist ein Magnetfeldsensor 7 angeordnet, der zur Erfassung des Flusses im Magnetkern 2 dient. Der Magnetkern 2 ist mit Bügeln 8 bis 11 an der Platte 1 befestigt. Die Bügel 8 bis 11 bestehen aus leitendem Material und sind durch Leiterbahnen 12 mit den Anschlüssen 13 und 14 zu einer Spule 15 verbunden.

Da der Ringkern 5 aus hochpermeablem, weichmagnetischem Material besteht, kann man den Streufluß vernachlässigen, so daß die Bügel 8 bis 11 trotz ihres Abstandes voneinander zusammen mit den Leiterbahnen 12 wie eine "Rogowskispule" wirken, die normalerweise aus um einen Torus dichtgewickelten Windungen besteht, die einen Stromleiter umgeben und eine der Stromänderungsgeschwindigkeit des Stromes i1 im Stromleiter 3 proportionale Spannung liefern. Hier wird also der Magnetkern 2 ausgenutzt um zu gewährleisten, daß durch alle Bügel 8 bis 11 der gleiche Fluß hindurchtritt. Andererseits werden die Bügel 8 bis 11 ausgenutzt, um den Magnetkern 2 auf der Platte 1 zusätzlich zu fixieren.

Es bleibt aber anzumerken, daß der der Erfindung zugrundeliegende Effekt auch mit einer Ringspule erzielt werden kann, die getrennt vom Magnetkern 2 angeordnet ist. Voraussetzung dafür, daß tatsächlich die Spannung an den Anschlüssen 13 und 14 der Stromänderung proportional ist, ist eine solche Dimensionierung des Ringkerns 5, daß dieser bei den vorkommenden Strömen nicht in Sättigung gelangt. Es kann daher vorteilhaft sein, anstelle des einen Luftspaltes 6, mehrere am Umfang des Ringkerns 5 verteilte Luftspalte vorzusehen und - um die Wirkung der Streuflüsse im Bereich der Luftspalte möglichst auszuschalten - die Bügel 8 bis 11 in Bereichen des Ringkerns 5 ohne Luftspalt anzuordnen.

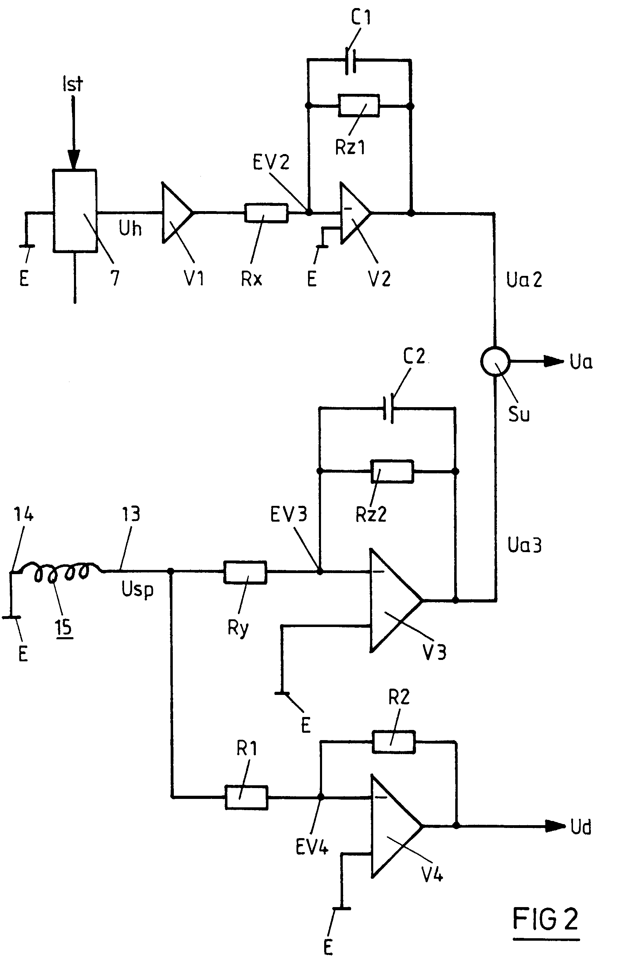

Fig. 2 zeigt nun eine Schaltung, mit der aus den Ausgangssignalen (Spannungen) des Magnetfeldsensors 7 und der Spule 15 eine Gesamtausgangsspannung Ua gewonnen werden kann, die ein Abbild des Stromes i1 im Stromleiter 3 auch bei Stromimpulsen und schnellen Stromänderungen liefert. Als Magnetfeldsensor 7 dient hier ein Hallgenerator, dessen Steuerstrom mit iSt bezeichnet ist und der in Verbindung mit dem Magnetfeld des Magnetkerns 2 eine Spannung Uh liefert, die an der rechten Seite des Magnetfeldsensors 7 abgegriffen wird, während die linke Seite mit Erde E verbunden ist. Die Spannung Uh dient nun als Eingangsspannung für einen Verstärker V1, der diese Spannung auf einen Wert vergrößert, der zur Ansteuerung von Widerständen und weiteren Verstärkern geeignet ist.

Der Ausgang des Verstärkers V1 ist über einen Widerstand Rx mit einem Eingang eines Verstärkers V2 verbunden, dessen zweiter Eingang ebenfalls an Erde angeschlossen ist. Der Ausgang des Verstärkers V2 ist über die Parallelschaltung eines Widerstandes Rzl und eines Kondensators C1 auf seinen Eingang EV2 zurückgeführt.

In ähnlicher Weise ist die Schaltung für die Spule 15 aufgebaut. Der Anschluß 14 der Spule 15 ist mit Erde E verbunden und der Anschluß 13, an dem die Spannung Usp der Spule abgegriffen werden kann, ist über den Widerstand Ry an den Eingang EV3 des Verstärkers V3 angeschlossen. Der zweite Eingang des Verstärkers V3 ist wiederum mit Erde E verbunden. Der Ausgang des Verstärkers V3 ist über einen Widerstand R2 und einen Kondensator C2 in Parallelschaltung wiederum auf den Eingang EV3 zurückgeführt. Außerdem sind die Ausgänge der Verstärker V2 und V3, an denen die Spannungen Ua2 und Ua3 anstehen, mit einem Summenpunkt Su verbunden, der aus diesen Spannungen die Summe bildet, die die Gesamtausgangsspannung Ua darstellt.

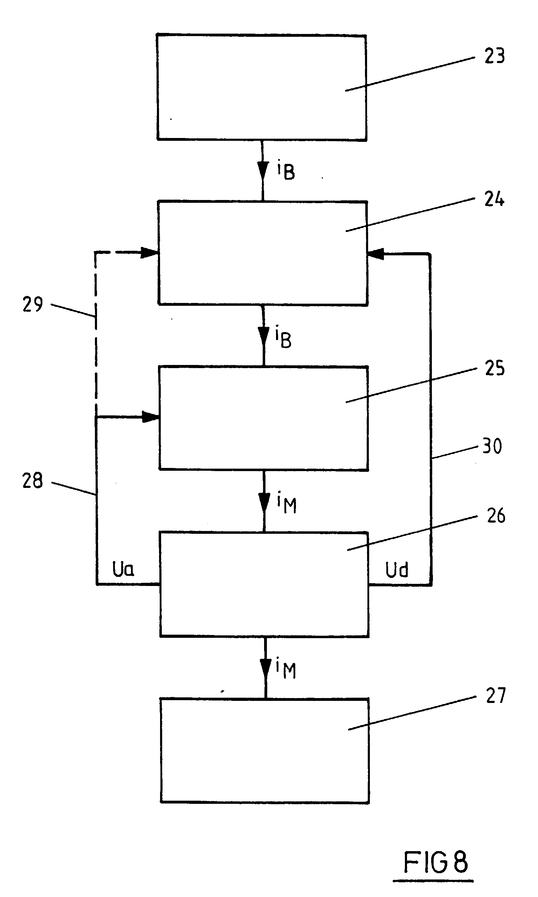

Für den Fall, daß der Stromsensor für die Messung, Erfassung oder Steuerung von Motorströmen oder anderen vorwiegend induktiven Verbrauchern herangezogen wird, kann man annehmen, daß im Betrieb eine schnelle Stromänderung nicht stattfinden wird. Allerdings können sich bei diesen Anwendungen trotzdem schnelle Stromänderungen ergeben, die dann aber immer ein Zeichen eines Kurzschlusses sind. Legt man diese Überlegungen zugrunde, läßt sich bei dem erfindungsgemäßen Stromsensor die Spule 15 zusätzlich dazu verwenden, ein Ausgangssignal bereitzustellen, das der Stromänderung abhängig von der Zeit proportional ist. Hierzu ist der Anschluß 13 der Spule 15 über einen Widerstand R1 mit dem Eingang EV4 eines Verstärkers V4 verbunden, dessen zweiter Eingang wiederum an Erde E angeschlossen ist. Der Ausgang des Verstärkers V4 ist hier über einen Widerstand R2 mit dem Eingang EV4 rückgekoppelt. Hierdurch ergibt sich am Ausgang des Verstärkers V4 eine Spannung, die proportional der Stromänderung in der Spule 15 ist. Dieser Ausgang läßt sich bei der Speisung von Verbrauchern mit hohen Induktivitäten zur Kurzschlußüberwachung heranziehen, wie anhand von Fig. 8 noch näher erläutert wird.

Die Wirkungsweise dieser Schaltung nach Fig. 2 ist nun folgende: Die im Verstärker V1 verstärkte Spannung Uh ist proportional dem Strom il im Stromleiter 3 (Fig. 1) und liegt über den Widerstand Rx am Verstärkereingang EV2 des Verstärkers V2 an. Durch die sehr hohe Verstärkung des Verstärkers V2 wird jetzt die Spannung am Ausgang dieses Verstärkers Ua2 soweit geändert, daß - bedingt durch den Spannungsabfall an dem Widerstand Rx einerseits und an der Parallelschaltung des Widerstands Rzl und des Kondensators C1 andererseits - der Eingang EV2 des Verstärkers wieder annähernd auf Erdpotential liegt. Für niedrige Frequenzen ist der Widerstand des Kondensators C1 sehr hoch, so daß er in dieser Parallelschaltung vernachlässigt werden kann. Man erhält also eine proportionale Verstärkung, so daß in diesem Bereich die Spannung Ua2 proportional der Spannung Uh und damit proportional dem Strom il im Stromleiter 3 ist. Bei hohen Frequenzen ist jedoch der Widerstand der Parallelschaltung im wesentlichen durch den Widerstand des Kondensators C1 bestimmt. Dieser Widerstand nimmt mit der Frequenz ab, so daß der Verstärkungsfaktor des Verstärkers V2 mit höher werdender Frequenz kontinuierlich zurückgeht. Oberhalb eines Grenzder Frequenz ist die Spannung Ua2 dann nicht mehr proportional zu dem zu messenden Strom sondern wird gegenüber der von der Spule 15 über den Verstärker V3 gelieferten Spannung Ua3 praktisch vernachlässigbar.

Anders verhält es sich mit der Spannung Usp, die in der Spule 15 erzeugt wird. Auch der Verstärker V3 hat eine sehr hohe Verstärkung, so daß bedingt durch die Rückkopplung über die Parallelschaltung des Widerstandes Rz2 und des Kondensators C2, der Eingang EV3 des Verstärkers V3 wiederum nahezu auf Erdpotential gehalten wird. Im Gegensatz zur Spannung Uh ist allerdings die Spannung Usp nicht proportional zu dem Strom i1 im Stromleiter 3, sondern ist bei niedriger Frequenz gleich Null und steigt proportional mit der Frequenz (und natürlich auch mit dem Strom i1) an. Dies hat zur Folge, daß die Spannung Ua3 am Ausgang des Verstärkers V3 bei konstantem Strom i1 und bei steigender Frequenz dieses Stromes kontinuierlich ansteigt; jedoch zunächst gegenüber der Spannung Ua2 vernachlässigbar klein ist.

Die Dimensionierung der Widerstände und Kondensatoren ist nun so vorzunehmen, daß in dem gleichen Grenzfrequenzbereich, in dem die Spannung Ua2 nicht mehr proportional zur Spannung Uh ist, auch die Spannung Ua3 nicht mehr proportional zur Spannung Usp wächst. Weiterhin wird hierdurch erreicht, daß bei steigender Frequenz (und immer noch gleichem Strom i1) die Verstärkung des Verstärkers V3 gerade so abnimmt, wie die Spannung Usp mit der Frequenz ansteigt. Dies ergibt sich, da die Spannung Usp mit der Stromänderungsgeschwindigkeit gerade so zunimmt, wie der Widerstand des Kondensators C2 abnimmt. Man erhält also eine Spannung Ua3, die bei hohen Frequenzen dem Strom i1 im Stromleiter 3 wiederum proportional ist. Bei sehr hohen Frequenzen ist die Spannung Ua2 soweit abgefallen, daß sie jetzt gegenüber der Spannung Ua3 vernachlässigbar ist, so daß die aus der Summe der Spannungen Ua2 und Ua3 gebildete Gesamtausgangsspannung Ua im gesamten Frequenzbereich sich nur mit der Größe des Stromes il, aber nicht mit dessen Frequenz ändert.

Die auch in dieser Schaltung bei hohen Frequenzen sich bemerkbar machenden induktiven Einkopplungen in den Zuleitungen zum Magnetfeldsensor und in der übrigen Schaltung, die bei bekannten direktabbildenden Stromsensoren die Abbildungsspannung (hier Spannung Ua2) stark beeinflussen, haben hier keinen Einfluß mehr auf die Gesamtausgangsspannung Ua, da in diesen Frequenzbereichen ohnehin die Spannung Ua2 gegenüber der Spannung Ua3 vernachlässigbar ist.

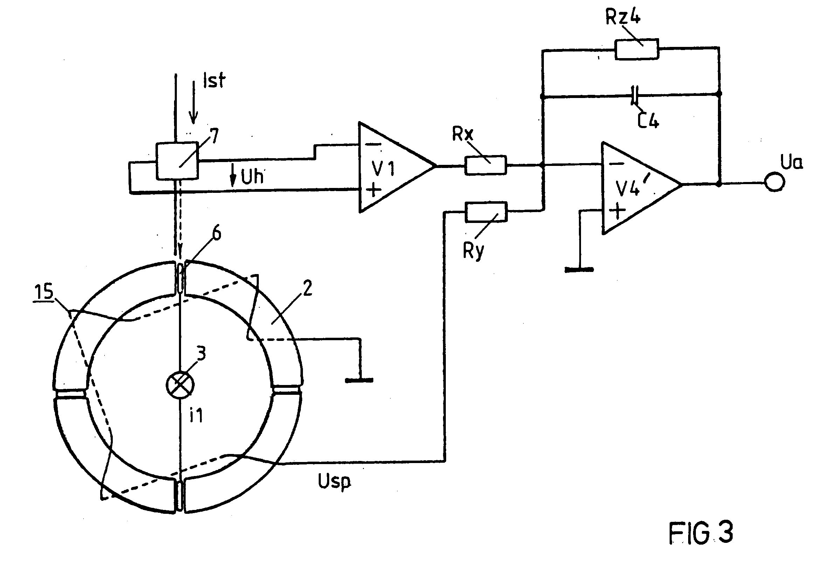

Fig. 3 zeigt nun eine vereinfachte Ausführungsform der Schaltung. Der Stromleiter 3 wird wiederum von einem Magnetkern 2 umgeben, der hier vier Luftspalte aufweist mit mindestens einem Magnetfeldsensor 7 in einem Luftspalt 6 und einem Steuerstrom ist, wenn als Magnetfeldsensor wiederum ein Hallelement verwendet wird. Die Ausgangsspannung Uh ist wieder an einen Verstärker V1 angeschlossen. Anstelle der Verstärker V2 und V3 in Fig. 2 ist jetzt nur ein Verstärker V4' vorgesehen (Fig. 3).

Die Anpassung der Kennlinien an den Grenzfrequenzbereich, an dem praktisch die Ablösung der Spannung Ua2 von der Spannung Ua3 in Fig. 2 erreicht wird, geschieht hier durch die Dimensionierung der wiederum vorhandenen Widerstände Rx und Ry, während nur noch eine Parallelschaltung aus dem Widerstand Rz4 und dem Kondensator C4 zum Verstärker V4 genügt, um bei zunehmender Frequenz die Verstärkung des Verstärkers V4 soweit zu vermindern, daß die Gesamtausgangsspannung A wiederum nur dem Strom il, nicht aber dessen Frequenz proportional ist.

Die Grenzfrequenz wird hier für die Spannungen des Magnetfeldsensors 7 und der Spule 15 von denselben Bauelementen (Widerstand Rz4 und Kondensator C4) bestimmt. Dies hat den Vorteil, daß es nur eine Grenzfrequenz gibt, unabhängig von Schwankungen der Widerstands- oder Kapazitätswerten und auch temperaturunabhängig.

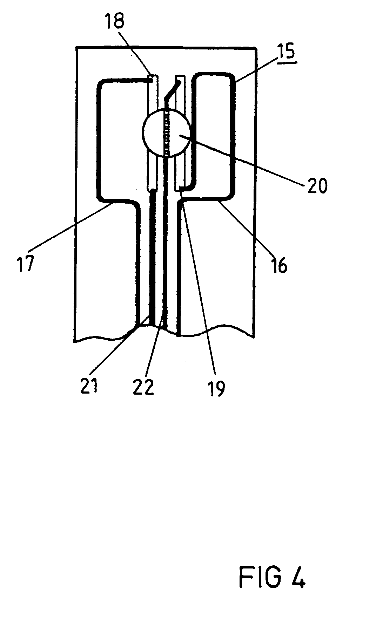

Während die Spule 15 in den Fig. 1 und 3 mit je vier Wicklungen ausgeführt wurde, ist im Ausführungsbeispiel nach Fig. 4 diese Spule dadurch gebildet, daß die Meßleitungen 16 und 17, die zu den Meßanschlüssen 18 und 19 eines Hallelementes 20 führen, so verlegt, daß sie eine Windung bilden, die von dem Magnetfeld des Magnetkerns 2 durchsetzt wird. Hier muß die von den Meßleitungen 16 und 17 eingeschlossene Fläche und der durch die Steuerleitungen 21 und 22 des Hallelementes fließende Strom so aufeinander abgestimmt werden, daß sich die gewünschte Ausgangsspannung proportional zum Strom il im Stromleiter 3 bildet. Anstelle der Dimensionierung der Widerstände Rx und Ry in den Fig. 2 und 3 tritt hier also die Auswahl der Größe des Steuerstromes im Zusammenhang mit der von den Meßleitungen 16 und 17 eingeschlossenen Fläche. Bei der Anordnung nach Fig. 4 wird also die in der Spule 15 induzierte Spannung unmittelbar zu der Meßspannung Uh des Hallelementes addiert und dann einer entsprechend dimensionierten Auswerteschaltung zugeführt.

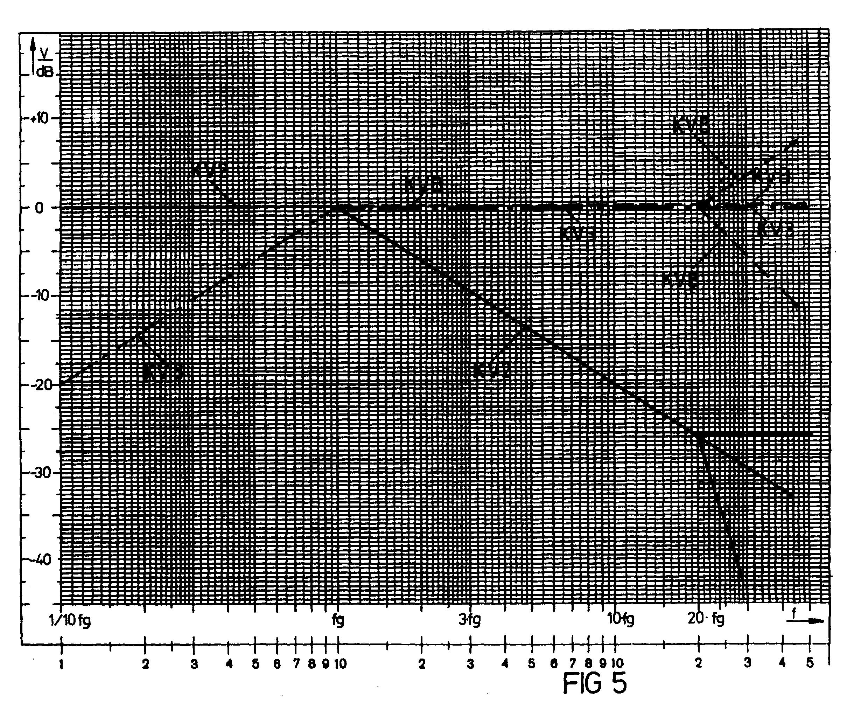

Fig. 5 zeigt den durch alle beschriebenen Schaltungsarten erreichbaren Verstärkungsverlauf der durch Kondensatoren und Widerstände beschalteten Verstärker. Die gestrichelt dargestellte Kurve KVB zeigt die Verstärkung eines eingangs beschriebenen bekannten Stromsensors mit über den gesamten Frequenzbereich konstantem Verstärkungsfaktor. In der Darstellung nach Fig. 5 teilt sich diese Kurve in sternförmig auseinandergehende Strahlen auf. Hiermit wird angedeutet, daß sich bei diesen Frequenzen induktive Einkopplungen bemerkbar machen, die vom Aufbau der Auswerteschaltung und vom Verlauf der Zuleitungen zum Magnetfeldsensor abhängen, dadurch nicht voraussagbar sind und die Abbildung des tatsächlich fließenden Stromes il verfälschen.

Nach der in Fig. 2 beschriebenen Schaltung entspricht der Verlauf der als ausgezogene Linie dargestellten Kurve KV2 der Verstärkung des Verstärkers V2, (bzw. dessen Ausgangsspannung für den Fall eines als konstant angenommenen Stromes il). Der Grenzfrequenzbereich liegt bei Frequenzen in der Nähe der Grenzfläche fg. Diese wird durch die Dimensionierung der Parallelschaltung von bspw. Widerstand Rzl und Kondensator C1 bestimmt und ist erreicht, wenn deren Wechselstromwiderstände gleich groß sind.

Da oberhalb des Bereiches um die Grenzfrequenz fg der Rückkopplungswiderstand des Verstärkers V2 im wesentlichen durch den Kondensator C1 bestimmt wird, sinkt in diesem Bereich der Verstärkungsfaktor (Kurve KV2) schnell ab und beträgt bei 10 * fg (Wert = -20 dB) nur noch 1/10 des Anfangswertes. Oberhalb von etwa 20 * fg teilt sich die Kurve dann wieder - wie beim bekannten Stromsensor - auf, da auch hier die induktiven Einkopplungen nicht vermieden werden. Allerdings liegt die Verstärkung hier schon unter -20 dB, so daß diese induktiven Einkopplungen praktisch nichts mehr zur Ausgangsspannung Ua in Fig. 2 beitragen, die von der Summe der Verstärkungsfaktoren der Verstärker V2 und V3 gebildet wird.

Die strichpunktiert dargestellte Kurve KV3 stellt nun die Ausgangsspannung des Verstärkers V3 dar, der ja von der induzierten Spannung in der Spule 15 beaufschlagt wird. Die Parallelschaltung von Widerstand Rz2 und Kondensator C2 ist auf die gleiche Grenzfrequenz fg wie der Verstärker V2 eingestellt. Dadurch steigt die Ausgangsspannung unterhalb von fg mit der stetig anwachsenden Eingangsspannung an und wird - wie beim Verstärker V2 - oberhalb von fg durch den dort dominierenden Einfluß des Kondensators C2 abgeschwächt. Bei diesen höheren Frequenzen hält sich dann die Abschwächung durch den Kondensator C2 die Waage mit dem Anstieg der induzierten Spannung in der Spule 15, so daß sich eine konstante Verstärkung ergibt. Der Einfluß induktiver Einkopplungen oberhalb von etwa 20 * fg ist damit vernachlässigbar, so daß das Frequenz- bzw. das Impulsverhalten des erfindungsgemäßen Stromsensors gegenüber bekannten direktabbildenden Stromsensoren stark verbessert ist.

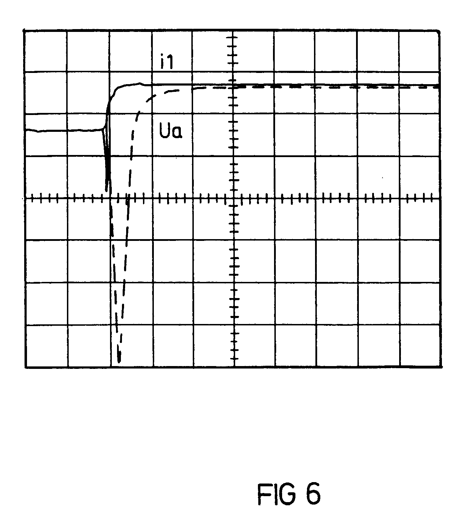

Fig. 6 zeigt nun für eine plötzliche Änderung des Stromes il die Gesamtausgangsspannung Ua eines direktabbildenden Stromsensors ohne zusätzliche elektrische Spule, beispielsweise mit einer Auswerteschaltung entsprechend der oberen Hälfte in Fig. 2 zur Bildung der Spannung Ua2, wenn diese - um über einen möglichst großen Bereich eine proportionale Spannung zum Strom il zu erhalten - ohne den Kondensator C1 ausgeführt wäre (Kurve KVB in Fig. 5).

Der Verlauf der gestrichelt dargestellten Spannungskurve Ua zeigt nun, daß sich zwar eine gute Anpassung an den geänderten Wert von il einstellt, daß dies aber unmittelbar nach der plötzlichen Änderung von il nicht der Fall ist.

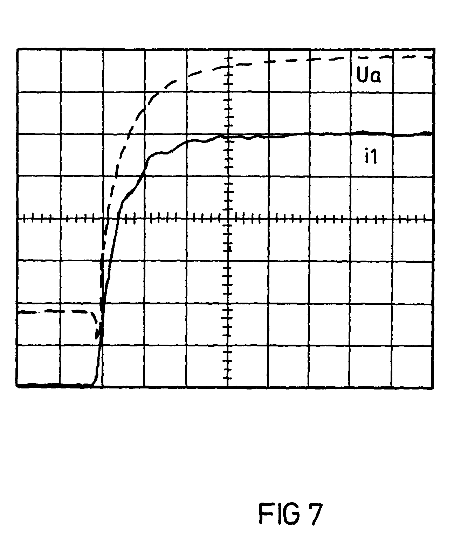

Die dargestellten Kurven sind in Fig. 7 für den Fall dargestellt, daß eine Anordnung nach der Erfindung vorgenommen wird. Hier sieht man - im vergrößerten Maßstab - daß die gestrichelt dargestellte Kurve Ua unmittelbar der Änderung des Stromes il (durchgezogene Kurve) folgt. Das dynamische Verhalten des erfindungsgemäßen direktabbildenden Stromsensors also wesentlich verbessert ist.

Wie eingangs anhand der Fig. 2 bereits kurz erläutert wurde, läßt sich die Spule 15 des erfindungsgemäßen Stromsensors zusätzlich zur Gewinnung eines Ausgangssignals benutzen, das der Stromänderung im zu überwachenden Leiter proportional ist. Dieses zusätzliche Ausgangssignal ist beispielsweise bei einer Motorsteuerung einsetzbar und kann dazu führen, daß beim Kurzschluß eine Abschaltung schon dann ermöglicht wird, wenn der Kurzschlußstrom den Nennstrom noch nicht überschritten hat.

In Fig. 8 ist ein Blockschaltbild für eine derartige Motorsteuerung dargestellt. Dabei wird eine Leistungsstromversorgung 23, der eine Schaltung zur Kurzschlußüberwachung 24 nachgeschaltet ist, gezeigt. Über die Schaltung 24 zur Kurzschlußüberwachung wird ein Motorregler 25 gespeist. Dieser wandelt den Betriebsstrom iB in einen Motorstrom iM um, der über den erfindungsgemäßen Stromsensor 26 den Motor 27 speist. Der Stromsensor 26 hat nun (wie in Fig. 2 beispielsweise dargestellt), zwei Ausgänge Ua und Ud, wobei der Ausgang Ua eine dem Strom proportionale Spannung darstellt, die beispielsweise über die Leitung 28 auf den Motorregler 25 als Istwert für den Motorstrom einwirkt. Zusätzlich kann dieser Ausgang des Stromsensors 26 noch über eine gestrichelt dargestellte Leitung 29 auf die Kurzschlußüberwachung 24 gegeben werden. Besonders vorteilhaft ist es jedoch, wenn man die der Stromänderung proportionale Spannung Ud am Ausgang des Verstärkers V4 in Fig. 2 ebenfalls verwendet und diese Spannung über eine Leitung 30 ebenfalls auf die Kurzschlußüberwachung 24 zurückführt. Da der Motor 27 relativ große Induktivitäten in seinen Wicklungen besitzt, kann man davon ausgehen, daß im normalen Betrieb keine schnellen Stromänderungen auftreten können.

Eine schnelle Stromänderung ist daher eindeutig als Zeichen für einen vorhandenen Kurzschluß zu werten. Damit ist es möglich, die Kurzschlußüberwachung 24 so auszuführen, daß der Motor 27 bei Überschreitung eines bestimmten Wertes für die Spannung Ud erfolgt. Man erhält also bei Anwendung des erfindungsgemäßen Stromsensors zusätzlich zu einer dem zu messenden Strom proportionalen Spannung auch eine Ausgangsgröße, die der Stromänderung proportional ist und die mindestens bei Verbrauchern mit großen Induktivitäten zur besonders schnellen Kurzschlußabschaltung herangezogen werden kann.

## Patentansprüche

1. Direktabbildender Stromsensor mit einem vom zu messenden Strom (il) beeinflußten Magnetkern (2) und einem den Fluß im Magnetkern (2) erfassenden Magnetfeldsensor (7), dessen Ausgangssignal einer Auswerteschaltung zugeführt wird und als Meßgröße für den zu messenden Strom (il) dient, wobei zur Verbesserung der Stromabbildung bei schnellen Stromänderungen und hohen Frequenzen zusätzlich zum Magnetfeldsensor (7) eine ebenfalls vom Magnetfluß des zu messenden Stroms (il) beeinflußte elektrische Spule (15) vorgesehen ist, dadurch gekennzeichnet, daß die in dieser Spule (15) induzierte, der Stromänderung des zu messenden Stroms proportionale Spannung (Usp) ebenfalls der Auswerteschaltung zugeführt wird und daß die Auswerteschaltung Verstärkerschaltungen enthält, deren frequenzabhängige Verstärkerkennlinien durch entsprechende Dimensionierung so gewählt sind, daß bei niedrigen Frequenzen vorwiegend das Ausgangssignal des Magnetfeldsensors (7) und bei hohen Frequenzen vorwiegend die in der Spule induzierte Spannung (Usp) zur Bildung des Gesamtausgangssignals des Stromsensors beiträgt.

2. Direktabbildender Stromsensor nach Anspruch 1, **dadurch gekennzeichnet,** daß die zusätzliche, vom Magnetfluß des zu messenden Stromes (il) beeinflußte elektrische Spule aus Windungen besteht, die den Magnetkern (2) mit dem Magnetfeldsensor (7) umschließen.

3. Direktabbildender Stromsensor nach Anspruch 2, **dadurch gekennzeichnet,** daß die elektrische Spule aus Bügeln (8 - 11) besteht, die den Magnetkern auf einer Unterlage festhalten und daß die Bügel durch eine gedruckte Schaltung in der Unterlage zu einer Spule miteinander verbunden sind.

4. Direktabbildender Stromsensor nach Anspruch 1, **dadurch gekennzeichnet,** daß der Magnetkern einen Luftspalt (6) aufweist, in dem sich der Magnetfeldsensor (7) befindet und daß die Zuleitungen zu dem Magnetfeldsensor so geführt sind, daß sie eine Windung bilden, die mindestens von einem Teil des Flusses des Magnetkerns durchsetzt wird, so daß sich die vom Magnetfeldsensor erzeugte Spannung zu derjenigen Spannung addiert, die in den die Windung bildenden Zuleitungen induziert wird.

5. Direktabbildender Stromsensor nach Anspruch 1 oder 2, **dadurch gekennzeichnet,** daß die Ausgangssignale des Magnetfeldsensors und der Spule über Verstärkerschaltungen verstärkt werden, die bis zu einem Grenzfrequenzbereich ein weitgehend proportionales Verstärkungsverhalten aufweisen und deren Verstärkungsfaktor sich bei höheren Frequenzen mit zunehmender Frequenz vermindert.

6. Direktabbildender Stromsensor nach Anspruch 5, **dadurch gekennzeichnet,** daß die Verstärkungsverminderung oberhalb des Grenzfrequenzbereiches bei der der Spule nachgeschalteten Verstärkerschaltung so gewählt ist, daß der Anstieg der induzierten Spannung in der Spule bei gleichbleibendem zu messenden Strom (il) mit steigender Frequenz durch die damit verbundene Verringerung der Verstärkung kompensiert wird.

7. Direktabbildender Stromsensor nach einem der vorhergehenden Ansprüche, **dadurch gekennzeichnet,** daß zur Bildung des Gesamtausgangssignals die Ausgangssignale des Magnetfeldsensors und der Spule zueinander addiert werden.

8. Direktabbildender Stromsensor nach einem der vorhergehenden Ansprüche, **dadurch gekennzeichnet,** daß als Magnetfeldsensor ein Hallgenerator (20) vorgesehen ist, dessen Ausgangsspannung gegebenenfalls nach Verstärkung über eine Spannungsteilerschaltung (Widerstände Rx und Ry) dem Eingang eines gemeinsamen Verstärkers (V4') mit abhängig von einem Grenzfrequenzbereich zunächst proportionalen und dann abnehmenden Verstärkung zugeführt ist.

9. Direktabbildender Stromsensor nach einem der vorhergehenden Ansprüche, **dadurch gekennzeichnet,** daß zur Bildung des Frequenzganges mit abnehmender Verstärkung oberhalb eines Grenzfrequenzbereiches der Ausgang eines Verstärkers über die Parallelschaltung eines Kondensators (C4) mit einem Widerstand (Rz4) an den Eingang rückgekoppelt ist.

10. Direktabbildender Stromsensor nach einem der vorhergehenden Ansprüche, **dadurch gekennzeichnet,** daß die Ausgangsspannung der Spule (15) zusätzlich zur Bildung eines Ausgangswertes (Ud), der der Stromänderung des zu messenden Stromes proportional ist, herangezogen wird.

11. Direktabbildender Stromsensor nach Anspruch 10, **dadurch gekennzeichnet**, daß das zusätzliche der Stromänderung proportionale Ausgangssignal (Ud) zur Kurzschlußabschaltung herangezogen wird, falls der vom Stromsensor zu messende Strom Betriebsstrom eines Verbrauchers mit relativ großer Induktivität ist.

## Claims

1. Direct-measurement current sensor having a magnet core (2) which is influenced by the current (il) to be measured and having a magnetic field sensor (7) which detects the flux in the magnet core (2) and whose output signal is supplied to an evaluation circuit and is used as a measurement variable for the current (i1) to be measured, an electrical coil (15), which is likewise influenced by the magnetic flux of the current (i1) to be measured, being provided in addition to the magnetic field sensor (7) in order to improve the current measurement in the case of rapid current changes and high frequencies, characterized in that the voltage (Usp) which is induced in this coil (15) and is proportional to the current change of the current to be measured likewise is supplied to the evaluation circuit, and in that the evaluation circuit contains amplifier circuits whose frequency-dependent amplifier characteristics are chosen by appropriate design such that the output signal from the magnetic field sensor (7) makes the predominant contribution at low frequencies and the voltage (Usp) induced in the coil makes the predominant contribution at high frequencies to forming the overall output signal from the current sensor.

2. Direct-measurement current sensor according to Claim 1, characterized in that the additional electrical coil which is influenced by the magnetic flux of the current (il) to be measured comprises turns which enclose the magnet core (2) with the magnetic field sensor (7).

3. Direct-measurement current sensor according to Claim 2, characterized in that the electrical coil is composed of clips (8-11) which hold the magnet core firmly on a base, and in that the clips are connected to one another by means of a printed circuit in the base to form a coil.

4. Direct-measurement current sensor according to Claim 1, characterized in that the magnet core has an air gap (6) in which the magnetic field sensor (7) is located, and in that the supply leads to the magnetic field sensor are routed such that they form a turn through which at least a portion of the flux of the magnet core passes, so that the voltage produced by the magnetic field sensor is added to that voltage which is induced in the supply leads which form the turn.

5. Direct-measurement current sensor according to Claim 1 or 2, characterized in that the output signals from the magnetic field sensor and from the coil are amplified via amplifier circuits which have a largely proportional gain response up to a cut-off frequency band and whose gain factor reduces at high frequencies as the frequency rises.

6. Direct-measurement current sensor according to Claim 5, characterized in that the gain reduction above the cut-off frequency band for the amplifier circuit connected downstream of the coil is chosen such that the rise in the induced voltage in the coil with increasing frequency and with the current (il) to be measured remaining constant is compensated for by the reduction in the gain linked to this.

7. Direct-measurement current sensor according to one of the preceding claims, characterized in that the output signals from the magnetic field sensor and from the coil are added to one another in order to form the total output signal.

8. Direct-measurement current sensor according to one of the preceding claims, characterized in that a Hall generator (20) is provided as the magnetic field sensor, whose output voltage is supplied, if required after amplification, via a voltage divider circuit (resistors Rx and Ry) to the input of a common amplifier (V4') having a gain which, depending on the cut-off frequency band, is initially proportional and then reduces.

9. Direct-measurement current sensor according to one of the preceding claims, characterized in that, in order to form the frequency response with reducing gain above a cut-off frequency band, the output of an amplifier is fed back to the input via the parallel circuit formed by a capacitor (C4) and a resistor (Rz4).

10. Direct-measurement current sensor according to one of the preceding claims, characterized in that the output voltage from the coil (15) is additionally used to form an output value (Ud) which is proportional to the current change of the current to be measured.

11. Direct-measurement current sensor according to Claim 10, characterized in that the additional output signal (Ud) which is proportional to the current change is used for short-circuit disconnection if the current to be measured by the current sensor is the operating current of a load having a relatively high inductance.

## Revendications

1. Sonde de courant à action directe, comprenant un noyau magnétique (2) influencé par le courant à mesurer (il) et un détecteur de champ magnétique (7) détectant le flux dans le noyau magnétique (2) et dont le signal de sortie est amené à un circuit d'analyse et sert de grandeur de mesure pour le courant à mesurer (il), une bobine électrique (15) également influencée par le flux magnétique du courant à mesurer (il) étant prévue, en plus du détecteur de champ magnétique (7), en vue d'améliorer la représentation du courant en cas de variations rapides du courant et de fréquences élevées, caractérisée en ce que la tension (Usp) induite dans cette bobine (15), proportionnelle à la variation du courant à mesurer, est également amenée au circuit d'analyse et en ce que le circuit d'analyse contient des circuits amplificateurs dont les caractéristiques d'amplification, variables avec la fréquence, sont choisies, grâce à un dimensionnement approprié, de manière à ce qu'en présence de basses fréquences, ce soit principalement le signal de sortie du détecteur de champ magnétique (7), et en présence de hautes fréquences, ce soit principalement la tension (Usp) induite dans la bobine, qui contribue à la formation du signal total de sortie de la sonde de courant.

2. Sonde de courant à action directe selon la revendication 1, caractérisée en ce que la bobine électrique supplémentaire influencée par le flux magnétique du courant à mesurer (il) est formée par des enroulements qui entourent le noyau magnétique (2) avec le détecteur de champ magnétique (7).

3. Sonde de courant à action directe selon la revendication 2, caractérisée en ce que la bobine électrique est formée par des étriers (8 - 11) qui maintiennent le noyau magnétique sur une base et en ce que les étriers sont reliés les uns aux autres par un circuit imprimé dans la base de manière à former une bobine.

4. Sonde de courant à action directe selon la revendication 1, caractérisée en ce que le noyau magnétique comporte un entrefer (6) dans lequel se trouve le détecteur de champ magnétique (7) et en ce que les fils d'amenée menant au détecteur de champ magnétique sont posés de manière à former un enroulement traversé au moins par une partie du flux du noyau magnétique, de manière à ce que la tension produite par le détecteur de champ magnétique s'ajoute à la tension induite dans les fils d'amenée formant l'enroulement.

5. Sonde de courant à action directe selon la revendication 1 ou 2, caractérisée en ce que les signaux de sortie du détecteur de champ magnétique et de la bobine sont amplifiés par des circuits amplificateurs qui ont un comportement amplificateur largement proportionnel jusqu'à une gamme de fréquences limites et dont le facteur d'amplification diminue, aux fréquences élevées, à mesure que la fréquence augmente.

6. Sonde de courant à action directe selon la revendication 5, caractérisée en ce que la réduction d'amplification au-dessus de la gamme des fréquences limites est choisie, pour le circuit amplificateur monté en aval de la bobine, de manière à ce que l'augmentation de la tension induite dans la bobine soit compensée, pour un courant à mesurer (i1) constant de fréquence croissante, par la diminution de l'amplification liée à cette croissance de la fréquence.

7. Sonde de courant à action directe selon l'une des revendications précédentes, caractérisée en ce que, pour former le signal total de sortie, on additionne les signaux de sortie du détecteur de champ magnétique et de la bobine.

8. Sonde de courant à action directe selon l'une des revendications précédentes, caractérisée en ce que l'on prévoit, en tant que détecteur de champ magnétique, un générateur Hall (20) dont la tension de sortie est amenée - le cas échéant après amplification - par le biais d'un montage diviseur de tension (résistances Rx et Ry), à l'entrée d'un amplificateur commun (V4') dont l'amplification, en fonction d'une gamme de fréquences limites, est d'abord proportionnelle, puis décroissante.

9. Sonde de courant à action directe selon l'une des revendications précédentes, caractérisée en ce que, pour former la réponse fréquentielle avec amplification décroissante au-dessus d'une gamme de fréquences limites, la sortie d'un amplificateur est couplée rétroactivement à son entrée par le biais du montage en parallèle d'un condensateur (C4) et d'une résistance (Rz4).

10. Sonde de courant à action directe selon l'une des revendications précédentes, caractérisée en ce que la tension de sortie de la bobine (15) est utilisée, en plus, pour former une valeur de sortie (Ud) qui est proportionnelle à la variation du courant à mesurer.

11. Sonde de courant à action directe selon la revendication 10, caractérisée en ce que le signal de sortie (Ud) supplémentaire proportionnel à la variation du courant est utilisé pour la coupure sur court-circuit dans le cas où le courant devant être mesuré par la sonde de courant est le courant de régime d'un utilisateur ayant une inductance relativement grande.
